# EUROPÄISCHE PATENTSCHRIFT

(11) **EP 1 639 619 B1**
(45) Veröffentlichungstag und Bekanntmachung des Hinweises auf die Patenterteilung: **07.12.2011**
(21) Anmeldenummer: 04736909.5
(22) Anmeldetag: 16.06.2004
(51) Int. Cl.: H01J 37/32, C04B 41/53, C03C 15/00, C03C 23/00, C23F 4/00, B08B 7/00

(54) **VERFAHREN UND VORRICHTUNG ZUM BEREICHSWEISEN ENTSCHICHTEN VON GLASPLATTEN**
METHOD AND DEVICE FOR REMOVING LAYERS IN SOME AREAS OF GLASS PLATES
PROCEDE ET DISPOSITIF POUR L'ENLEVAGE PARTIEL DE COUCHE SUR DES PLAQUES DE VERRE

(30) Priorität: 16.06.2003 AT 9332003
(43) Veröffentlichungstag der Anmeldung: 29.03.2006
(73) Patentinhaber: SAINT-GOBAIN GLASS FRANCE, 92400 Courbevoie (FR)
(72) Erfinder: FORSTNER, Helmut, A-3363 Hausmening (AT); HOFRICHTER, Alfred, 52062 Aachen (DE)
(74) Vertreter: Lendvai, Tomas
(86) Internationale Anmeldenummer: PCT/EP2004/006478
(87) Internationale Veröffentlichungsnummer: WO 2004/114357

(56) Entgegenhaltungen:
- EP-A- 0 709 348
- EP-A1- 1 410 852
- GB-A- 803 371
- US-A- 5 811 021
- US-A1- 2001 046 790
- US-A1- 2002 100 751
- US-B1- 6 238 582

## Beschreibung

Die Erfindung betrifft ein Verfahren mit den Merkmalen des einleitenden Teils von Anspruch 1 und eine Vorrichtung mit den Merkmalen des einleitenden Teils des Anspruches 17.

Transparente Substrate, insbesondere Scheiben aus Glas oder Kunststoff, aber auch Folien z. B. aus PET (Polyethylen-Terephthalat), werden für verschiedenste Anwendungen mit Beschichtungen versehen, bevor sie in ihren endgültigen Bearbeitungszustand gebracht werden. Beispielsweise werden zum Herstellen von Isolierglas (mindestens zwei mittels eines Abstandhalterahmens miteinander verbundene Einzelscheiben) Scheiben verwendet, die eine Beschichtung, insbesondere eine metallhaltige Beschichtung, tragen, um deren Durchlässigkeit, insbesondere für Wärmestrahlen, also im Infrarotbereich, zu reduzieren und um den Lichtdurchtritt insgesamt in der gewünschten Weise zu beeinflussen. Der gleiche Wärme reflektierende Zweck kann auch in Verbundscheiben realisiert werden, wobei dort die beschichtete Fläche im Verbund innen liegt.

Unter Beschichtung wird hier nicht nur eine einfache, einlagige Beschichtung verstanden, sondern insbesondere auch Schichtsysteme, die ihrerseits aus einer Mehrzahl von Einzelschichten, sei es metallischen, sei es oxidischen, sei es nitridischen, sei es organischen, oder Mischformen davon bestehen.

Auch Antireflex- oder Entspiegelungsschichten werden häufig auf solche transparenten Substrate aufgebracht, wobei die Wärme reflektierenden Schichtsysteme zumeist solche Entspiegelungsschichten ohnehin umfassen. Wieder andere Anwendungen oder Funktionen verlangen z. B. hydrophobe oder hydrophile Beschichtungen auf der Witterung ausgesetzten Substrat-Oberflächen.

Elektrisch leitfähige (metallhaltige) Beschichtungen können neben rein passiven Anwendungszwecken wie der erwähnten Wärmedämmung bzw. Infrarot-Reflexion auch als Flächenheizungen oder als Antennenfelder aktiv genutzt werden. Wasserabweisende und/oder selbstreinigende Eigenschaften solcher Beschichtungen sind ebenfalls bekannt, ebenso wie elektrochrome, thermochrome, etc... Beschichtungen. Derartige beschichtete (Fenster-)Scheiben werden im Baubereich, in Fahr- und Flugzeugen aller Art verwendet.

Es ist dabei von Vorteil, die Substrate, z. B. Floatglas, auf großen Flächen in entsprechenden Großanlagen zu beschichten (was zumeist durch Sputtern oder CVD geschieht), und die benötigten kleineren Substrate später zuzuschneiden und weiter zu verarbeiten.

Aus verschiedenen Gründen muss mitunter eine zunächst ganzflächige Beschichtung für den endgültigen Einsatzzweck des betreffenden Substrats teilweise / lokal begrenzt entfernt werden, was vor oder nach dem Zuschnitt geschehen kann.

Werden beispielsweise beschichtete Glasscheiben für Isolierglas verwendet, so werden diese so angeordnet, dass ihre beschichtete Seite in das Innere des Isolierglases, also zum Luftzwischenraum hin, weist, damit die mechanisch empfindliche Beschichtung möglichst gut geschützt ist. Problematisch bei Isolierglas mit wenigstens einer beschichteten Glasscheibe ist es, dass die üblichen Massen für den Randverbund (Butylkautschuk und Polysulfid als Versiegelungsmasse) auf der metallhaltigen Beschichtung schlecht haften und die Festigkeit des Randverbundes und die Diffusionsdichtheit nicht im gewünschten Ausmaß gewährleistet ist. Bei den Verbundscheiben ist die verringerte Haftung infolge der großflächigen Verklebung der starren Scheiben nicht sehr problematisch.

Ein ähnliches Haftungsproblem kann bei anders, insbesondere hydrophob oder hydrophil oder entspiegelnd, beschichteten Substraten bzw. Oberflächen immer dann auftreten, wenn auf diesen Oberflächen noch Zurüstteile, wie Dichtungen, Fensterheber-Mechanismen, adhäsiv befestigt werden sollen.

Generell bevorzugt man in solchen und ähnlichen Anwendungsfällen eine direkte Adhäsion der erwähnten und anderer Zurüstteile auf der unbeschichteten Substratoberfläche, da die verfügbaren Klebstoffe auf diese abgestimmt sind, bzw. um die Anzahl der beteiligten Grenzschichten so weit wie möglich zu minimieren.

Ein Problem insbesondere mit metallhaltigen Beschichtungen besteht auch darin, dass die Metallanteile oder -schichten unter Umwelteinflüssen korrodieren können. Dieses Schadenrisiko tritt insbesondere bei Isolierglas auf, das als sogenanntes Stufenglas ausgebildet ist, bei dem die Glasscheiben verschieden groß sind, so dass wenigstens eine der Glasscheiben von Stufenglas an wenigstens einem Randabschnitt über die andere Glasscheibe übersteht. Eine metallhaltige Beschichtung in dem Bereich der einen Glasscheibe, der über die andere Glasscheibe übersteht, kann korrodieren und so nicht nur unansehnlich werden, sondern auch die Dichtheit des Randverbundes von Isolierglas beeinträchtigen.

Das genannte Korrosionsproblem tritt aber auch bei beschichteten Substraten auf, die z. B. in Automobilen eingebaut werden (Windschutzscheiben oder generell Verbundscheiben). Zwar wird auch dort die Beschichtung auf einer im Verbund innen liegenden Fläche angeordnet, jedoch treten ohne besondere Schutzmaßnahmen auch dort Korrosionsschäden auf, die vom Rand des Substrats auf dessen Fläche vordringen.

Auch aus anderen Gründen kann es von Interesse sein, Teilflächen eines Substrates zu entschichten. Werden beispielsweise metallhaltig beschichtete Substrate als Antennen- oder Abschirmscheiben in metallische Rahmen eingebaut, so kann es erforderlich sein, die Beschichtung rundum oder wenigstens teilweise einen Abstand von diesem metallischen Rahmen einhalten zu lassen. Im Falle der Antenne in Automobilen wird beispielsweise dadurch eine kapazitive Kopplung des Antennenfeldes mit der Fahrzeugkarosserie vermieden. Ferner wird mitunter ein gezielter Strahlungsdurchgang durch eine (metallhaltig) beschichtete Fläche ("Kommunikationsfenster") benötigt, z. B. für Infrarot-Fernbedienungen, Mautkosten-Erfassungssysteme etc.

Im Falle von hydrophoben Beschichtungen kann es z.B. von Interesse sein, Bereiche für den Einsatz von Sensoren (Regensensor) oder generell ein Sichtfenster (beispielsweise im "Rückspiegelbereich" einer Seitenscheibe) zu entschichten.

Es kann schließlich auch nötig sein, eine Beschichtung aus mehreren Lagen nur teilweise in dem Sinn zu entfernen, dass nur eine oder mehrere Deckschichten eines Schichtsystems entfernt werden, während eine oder mehrere darunter liegende Schichten auf dem Substrat belassen werden. Dies wird man insbesondere dann bevorzugen, wenn eine oder mehrere verbleibende (Grund-)Schicht(en) bei der weiteren Verwendung des Substrats nicht hinderlich ist/sind oder sogar benötigt wird/werden.

Um diesen vorgenannten Problemen abzuhelfen bzw. den Anforderungen gerecht zu werden, ist es bekannt, die Beschichtung, insbesondere im Randbereich, mit einer bestimmten Breite bzw. auf einer bestimmten Fläche zu entfernen. Hierzu sind Vorrichtungen bekannt, mit welchen (metall-)beschichtete Glasscheiben, wenn sie für Isolierglas oder andere vorstehend erwähnte Einsatzzwecke verwendet werden sollen, wenigstens im Randbereich entschichtet werden können. Solche Vorrichtungen arbeiten mit thermischen Einrichtungen (Gasflammen oder Plasma, vgl. DE 34 03 682 C) oder mit mechanischen Einrichtungen, wie Schleif- oder Polierscheiben. Beispielhaft kann auf die EP 0 517 176 A (=DE 41 18 241 A), die DE 43 42 067 A oder die EP 603 152 A verwiesen werden.

Ein Vorteil der Plasma-Behandlung (bei Atmosphärendruck) zum Entfernen von Beschichtungen ist, dass es keine größeren Probleme mit dem Positionieren der Plasma-Behandlungseinrichtung bzw. des Plasmakopfes im Verhältnis zur Substratoberfläche gibt, während bei mechanisch-abrasiven Vorrichtungen ungenaues Positionieren der Schleifscheiben, insbesondere bei deren fortschreitendem Verschleiß, eine größere Störquelle ist.

Problematisch beim Entschichten von Glas- oder Kunststoffscheiben, auch wenn dies mit Hilfe von Plasma erfolgt, ist es allerdings, dass die Breite bzw. Fläche des entschichteten Bereiches während des Entschichtungsvorgangs nicht ohne weiteres geändert werden kann, so dass, wenn ein breiterer entschichteter Bereich benötigt wird, der zu entschichtende Bereich mehrfach abgefahren werden muss.

Störend bzw. verlangsamend wirkt sich dies beim Herstellen von Stufen-Isolierglas mit wenigstens einer beschichteten Glasscheibe aus. Wenn die beiden Glasscheiben unterschiedliche Abmessungen haben (z. B. "Stufenelemente") und die beschichtete Glasscheibe die größere Fläche hat, wird es notwendig, den Bereich, in dem sie entschichtet wird, in den überstehenden Bereichen breiter zu wählen als dies bisher möglich war.

Problematisch bei den bekannten Verfahren und Vorrichtungen zum Entschichten ist auch, dass bei Verwendung nur eines Plasmakopfes der zu entschichtende Bereich auch dann mehrfach abgefahren werden muss, wenn dieser Bereich ein nicht ganzzahliges Vielfaches, z.B. das Eineinhalbfache, der für das Entschichten wirksamen Breite des Plasmakopfes ist.

Solche mehrfachen Arbeitsgänge sind aus produktionstechnischer Sicht sehr hinderlich, weil sie den Zeitaufwand pro Substrat deutlich erhöhen können und damit die Wirtschaftlichkeit der Anlage verringern.

Mit manchen Anlagern konventioneller Bauart, die mit einem einzelnen Plasmakopf bzw. einer Plasmadüse ausgerüstet sind, kann z. B. durch Verändern der Strahlungsintensität des Plasmas die Breite des entschichteten Bereichs im Bereich von +/- 3 mm verändert werden.

Das Dokument US 6, 238, 582 B1 beschreibt ein Verfahren zum Ätzen von dünnen Schichten mit reaktiven Ionenstrahlen (Plasma) und eine zu dessen Durchführung geeignete Vorrichtung. Die zu behandelnden Substrate (Dünnschicht-Leseköpfe für Datenspeicher) sind in einer Kammer schwenkbar gelagert und werden einem Bündel von Ionenstrahlen ausgesetzt, wobei sich je nach Winkelstellung der Substrate bezüglich der Ionenstrahlen unterschiedliche Ätzwirkungen und -flächen ergeben können. Zwar wird diese Technik auch in gewisser Weise zum flächigselektiven Ätzen eingesetzt, jedoch sind die Substrate stets im wesentlichen vollflächig der Plasmastrahlung ausgesetzt.

EP 0 709 348 A1 beschreibt ein automatisierbares Verfahren zum Entfernen der elektrisch leitfähigen Beschichtung einer Glasscheibe im Randbereich, um dort Korrosion dieser Beschichtung zu verhindern. Die dort beschriebene Vorrichtung umfasst eine Transporteinrichtung für beschichtete Glasscheiben, und zwei Behandlungsvorrichtungen in Gestalt von Elektrodenköpfen. Diese Köpfe erzeugen über die Elektroden einen elektrischen Strom oder eine Entladung im Zusammenspiel mit der leitfähigen Beschichtung, verwenden jedoch kein Plasma. An einem Kopf können zwei Elektroden gleicher oder unterschiedlicher Form eingesetzt werden.

US 2002/0100751 A1 befasst sich mit dem Bearbeiten von Werkstücken mit Plasma, speziell mit Formgebung und Oberflächenbearbeitung. Es wird ausgeführt, dass hoch präzise "Fußabdrücke" des Plasma erzielt werden, die allerdings infolge einer seitlichen Ausbreitung des Plasma an der Werkstück-Oberfläche breiter als die eigentliche Düsenöffnung sind. Die dort verwendete Plasmafackel kann in einer Ausführungsform mehrere Köpfe umfassen, um die Ätzrate zu erhöhen. Dieses Dokument geht jedoch nicht auf das Entfernen von Beschichtungen von Substraten ein.

EP1410852A1 beschreibt ein Verfahren und eine Vorrichtung zum Entfernen einer Lackschicht auf Polymerbasis von der Oberfläche einer Fassade oder einer wand, wobei die Lackschicht durch einen auf die Oberfläche gerichteten Strahl eines atmosphärischen Plasmas verascht wird.

Der Erfindung liegt die Aufgabe zu Grunde, ein Verfahren und eine Vorrichtung anzugeben, welche es erlauben, die Breite des Bereiches, in dem eine vorhandene Beschichtung entfernt wird, auf das jeweils gewünschte Maß einzustellen.

Gelöst wird diese Aufgabe, was das Verfahren anlangt, mit den Merkmalen des verfahrensanspruches 1.

Insoweit die Vorrichtung betroffen ist, wird die der Erfindung zu Grunde liegende Aufgabe mit den Merkmalen des nebengeordneten Vorrichtungsanspruches 17 gelöst.

Vorteilhafte und bevorzugte Ausgestaltungen des erfindungsgemäßen Verfahrens und der erfindungsgemäßen Vorrichtung sind Gegenstand der den unabhängigen Ansprüchen jeweils nachgeordneten Unteransprüche.

Es kommt erfindungsgemäß darauf an, die Fläche, in der das Plasma auf das Substrat auftrifft (Arbeits-, Überdeckungs- oder Entschichtungsbereich), möglichst exakt mit der Fläche bzw. der Breite in Übereinstimmung zu bringen, auf der die Beschichtung entfernt werden muss. Dadurch wird nicht ausgeschlossen, dass das Plasma am Rand des Substrats auch vorbeistreichen kann, also auch über den zu entschichtenden Bereich hinaus sich erstreckt oder auch bei Bedarf die Stirnkante des Substrats trifft, von der ggf. auch die Beschichtung entfernt werden muss.

Da gemäß der Erfindung die Breite oder Fläche des Bereiches, in dem entschichtet wird, durch gesteuertes Verändern der Wirkbreite oder -fläche des aus einer Plasmaquelle (-Kopf, -Düse, ...) auf das beschichtete Substrat gerichteten Strahls aus Plasma gezielt verändert werden kann, ist es möglich, die Beschichtung im Zuge der Vorbereitung der Substrate für ihre späteren Verwendungen, wie sie vorstehend angegeben wurden, im jeweils gewünschten Ausmaß, insbesondere am Rand, rascher und flexibler zu entfernen als bisher.

Es sei angemerkt, dass unter dem hiernach wiederholt verwendeten Begriffen "Plasmaquelle" oder "Plasmakopf" generell sämtliche denkbaren Formen von Austrittsöffnungen zu verstehen sind, die ein Plasma oder einen Plasmastrahl mehr oder weniger gebündelt gezielt auf ein Substrat bzw. auf eine beschichtete Oberfläche leiten können. Es kann sich dabei um feste oder veränderliche Querschnitte handeln, wobei ferner zu Gruppen zusammengefasste Mehrfachköpfe bei Bedarf auch gegeneinander verstellbar sein könnten, um die Breite des Arbeitsbereiches und/oder die Plasmaenergie pro behandelter Flächeneinheit zu verändern.

Man gewinnt die Möglichkeit, in unterschiedlichen Bereichen und/ oder Randabschnitten eines Substrates unterschiedliche Entschichtungsbreiten zu wählen. Es ist insbesondere möglich, die Breite oder Fläche des Bereiches des Substrates, in dem dieses entschichtet wird, während der Behandlung zu ändern und so im besten Falle die gesamte Fläche in einem Arbeitsgang im benötigten Ausmaß zu entschichten.

Ein weiterer Vorteil dieser erfindungsgemäßen Vorgehensweise wird dadurch erreicht, dass man bei Bedarf auch zugleich mit der (Haupt-) Fläche des Substrats dessen Stirnkante oder -fläche entschichten kann, wenn dort auch noch eine Beschichtung vorhanden ist (overspray, ursprüngliche Kante beim Modell-Zuschnitt unbeeinträchtigt geblieben...). Sollte eine Entschichtung auf der Stirnkante erforderlich werden, so kann es gemäß der Erfindung zweckmäßig sein, die Plasmastrahlen dann auch direkt (im Wesentlichen in Normalenrichtung) auf diese Stirnkante auftreffen zu lassen. Hierzu kann es sinnvoll sein, die Plasmaköpfe oder -düsen entsprechend schwenkbar zu führen.

Vorteilhaft bei der Erfindung ist es in einer Ausführungsform, dass die Breite des entschichteten Bereiches unabhängig vom Durchmesser bzw. den Abmessungen eines einzelnen, zum Abgeben oder Auslassen eines Plasmastrahles verwendeten Plasmakopfes eingestellt werden kann.

Vorteilhaft bei der Erfindung ist es auch, dass die Taktzeit für die Rand- oder Flächenentschichtung auch bei breiteren Arbeits- oder Entschichtungsbereichen verkürzt wird, weil es nicht mehr notwendig ist, den zu entschichtenden Bereich mehrfach abzufahren, um die gewünschte Breite des entschichteten Bereiches (Streifens) zu erreichen.

Wenn gemäß der Erfindung beim Entschichten mit wenigstens zwei Plasmaköpfen gearbeitet wird, besteht in einer Ausführungsform die vorteilhafte Möglichkeit, die Plasmaköpfe relativ zum Rand der bereichsweise zu entschichtenden Glasscheibe so auszurichten, dass einer der Plasmaköpfe nur teilweise, z. B. nur mit einem Drittel seiner möglichen Wirkbreite, auf die Beschichtung einwirkt. So kann die Breite des zu entschichtenden Bereiches frei gewählt und während der Bearbeitung durch geeignetes Positionieren der Plasmaköpfe verändert werden, ohne dass der Rand der Glasscheibe mehrfach abgefahren werden muss.

Es ist natürlich im gleichen Sinne auch möglich, von mehreren Plasmaköpfen nur eine Teilmenge zu betreiben, wenn man einen schmalen Streifen entschichten will, und zusätzliche Köpfe oder Düsen zu aktivieren bzw. zu zünden, wenn man eine größere Breite oder Fläche entschichten will.

Wenn bei der erfindungsgemäßen Vorrichtung der Träger für die wenigstens zwei Plasmaköpfe um eine zur Ebene des zu entschichtenden Substrats senkrechte Achse verdrehbar ist, kann mit einer solchen Vorrichtung ein Substrat ringsum abgefahren werden, um seinen Randbereich umlaufend oder auf einem Umfangsteil zu entschichten. Wenn eine stufenlose Verdrehbarkeit der in mindestens einer Reihe angeordneten Plasmaköpfe vorgesehen ist, können auch beliebige Konturen (Formen- oder Modellscheiben) abgefahren werden, und die Ausrichtung der Reihe der Plasmaköpfe wird in vorteilhafter Weise stets senkrecht zum Rand der Glasscheibe sein. Veränderungen der Entschichtungsbreite können jedoch auch z. B. durch gezieltes Abweichen des Winkels der besagten Reihe zur Substratkante bzw. zur Vorschubrichtung des Entschichtungsfortschrittes erreicht werden.

Generell möchte man mit dem erfindungsgemäßen Behandlungsverfahren eine möglichst scharfe und saubere Kante der Beschichtung im Übergang von der beschichteten zur entschichteten Fläche erzielen. Nach einer vorteilhaften Weiterbildung der Erfindung kann man deshalb eine flächige Abschirmung vorsehen, die eine unkontrollierte Ausbreitung des Plasmastrahls bzw. der Plasmastrahlen aus den jeweils arbeitenden Köpfen verhindert. Mit einer geeigneten "mitfahrenden" Abschirmung, die z. B. die eigentliche momentane Arbeitsfläche (den aktuellen Überdeckungsbereich von Plasma und Substrat) rahmenartig umgibt, kann wieters verhindert werden, dass sich bereits entfernte Schichtpartikel in Form eines "oversprays" auf den noch zu bearbeitenden bzw. auf den angrenzenden Oberflächen, auf der Stirnkante oder gar (bei Arbeiten entlang des Substratrandes) auf dessen gegenüber liegender Oberfläche niederschlagen. Auch einen erneuten Niederschlag von bereits entfernten Schichtpartikeln auf bereits entschichteten Flächen kann eine solche flächige Abschirmung minimieren.

Die Abschirmung wird vorteilhaft gemeinsam mit den Plasmaköpfen bewegt und positioniert, wobei sie die verbleibende Beschichtung trotz geringstmöglichen Abstands tunlichst nicht berühren sollte.

Ergänzend kann in an sich bekannter Weise noch eine Vorrichtung mitgeführt werden, die die abgelösten Schichtpartikel unverzüglich abführt (z. B. pneumatische Absaugung). Eine solche Absaugung kann ggf. mit einer Abschirmung der vorerwähnten Art verbunden werden.

Mit einer Plasma-Behandlung unter Atmosphärendruck der hier beschriebenen Art kann man wesentlich einfacher als auf mechanischem Wege bei Bedarf nur Teilschichten eines Schichtsystems entfernen. Wenn die Teilschichten unterschiedlicher Natur (organisch, metallisch, oxidisch, nitridsch, hydrophob/hydrophil) sind, kann ggf. das Plasma schicht- oder materialspezifisch generiert werden (beispielsweise durch Verwenden von speziell auf das zu entfernende Material abgestimmten Ätz- oder reaktiven Gasen und/oder durch Steuerung der Prozessparameter wie z. B. Gasfluss, Fließgeschwindigkeit), um einen selektiven Ätz- oder Abbrennprozess zu fahren.

Auch durch Steuern der Energie bzw. des Aktivierungsgrades des Plasmas kann z. B. die Ein- oder Vordringtiefe des Plasmas und damit der Entschichtungsgrad senkrecht zur Substratoberfläche variiert werden.

Es kann schließlich auch gewünscht oder erforderlich sein, einen graduellen Übergang von der beschichteten Fläche zum entschichteten Bereich zu schaffen. Dies kann z.B. aus optischen, aber auch aus funktionalen Gründen erwünscht sein. Mit einer Aufteilung einer Plasmaquelle in mehrere individuell ansteuerbare Strahlköpfe oder -düsen gemäß der vorliegenden Erfindung lässt sich auch eine solche differenzierte Entschichtung erreichen. Man kann beispielsweise eine Teilmenge des Plasmas für eine vollständige Entschichtung auslegen, und eine andere Teilmenge für eine selektive Entschichtung nur von Deckschichten eines Schichtsystems.

Es sei ferner angemerkt, dass man mit dem erfindungsgemäßen Verfahren und der zugehörigen Vorrichtung auch nicht ebene (gebogene bzw. vorgeformte) beschichtete Substrate (beispielsweise für den Einbau in Fahrzeug-Front-, Heck- oder Seitenscheiben vorgesehene Glas- oder Kunststoffscheiben) behandeln bzw. entschichten kann, wenn die Vorrichtung zum Führen der Plasmaköpfe (und ggf. der vorerwähnten Abschirmung) die entsprechende Einstellbarkeit nicht nur in der Ebene, sondern auch im Raum aufweist. Auf gebogenen Substraten ist die Einhaltung des Normalen-Abstandes zwischen Plasmakopf und Substrat bzw. Beschichtung natürlich besonders kritisch.

Da das Prinzip der Plasma-Entschichtung an sich als bekannt vorausgesetzt werden kann, muss auf Einzelheiten des Plasma bzw. dessen Erzeugung nicht näher eingegangen werden. Kurz zusammengefasst wird nach der Erfindung, wie schon erwähnt, generell unter Atmosphärendruck gearbeitet. Das Plasma wird durch Energiezufuhr zu einem Gasstrahl erzeugt, der also vor dem Auftreffen auf das Substrat bzw. auf die Beschichtung mittels Zufuhr elektromagnetischer Energie (z. B. Gleichstrom, Radiofrequenz oder Mikrowellen) aktiviert wird, um seine Reaktivität, seine Energie, seine Temperatur, seine Ionisierung zu beeinflussen.

Man wird je nach dem zu entfernenden Schichttyp ein geeignet reaktives Plasma auswählen, wobei sämtliche Schichttypen der einleitend genannten Arten behandelt werden sollen. Es ist auch denkbar, das Plasma abgesehen von der Entschichtung an sich auch zum Aktivieren (oder anrauen) der Substratoberfläche zu nutzen, um z. B. die Adhäsion von später aufzubringenden Klebstoffen noch zu verbessern.

Weitere Einzelheiten, Merkmale und Vorteile des erfindungsgemäßen Verfahrens und der erfindungsgemäßen Vorrichtung ergeben sich aus der nachstehenden Beschreibung eines nicht einschränkenden Ausführungsbeispiels einer Vorrichtung an Hand der Zeichnungen.

Es zeigen
- Fig. 1: schematisch und in Schrägansicht eine Vorrichtung zum Durchführen des erfindungsgemäßen Verfahrens und
- Fig. 2: in vergrößertem Maßstab eine Einzelheit der Vorrichtung von Fig. 1,
- Fig. 3: ein Detail einer mit der Plasma-Behandlungsvorrichtung kombinierten Abschirm- und Absaugvorrichtung.

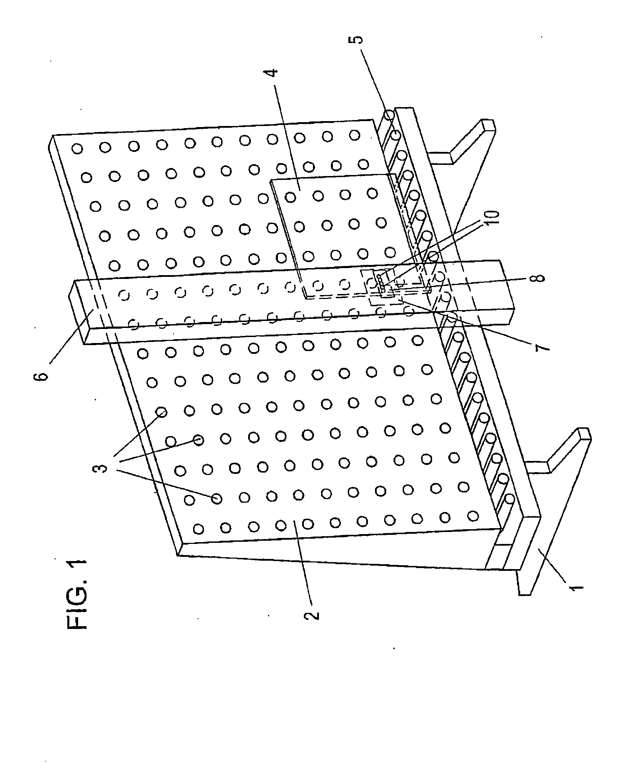

Eine in Fig. 1 gezeigte Vorrichtung besteht aus einem Grundgestell 1, in dem eine Stützwand 2 befestigt ist. Die Stützwand 2 kann, wie gezeigt, als Luftkissenwand ausgebildet sein und besitzt hierzu mehrere mit Druckluft beaufschlagte Öffnungen 3, so dass sich zwischen der Stützwand 2, die beispielsweise mit Filz belegt ist, und einer an ihr lehnenden Glasscheibe 4 ein Luftkissen ausbildet.

Die Bauart und Lage der Stützwand 2 ist an sich nicht wesentlich. Es sind auch Stützwände mit Rollen oder Walzen oder beliebigen anderen Gleitflächen denkbar. Natürlich kann die Stützwand abweichend von der Darstellung als Behandlungsebene für die Substrate auch flach oder leicht zur Horizontalen geneigt liegen.

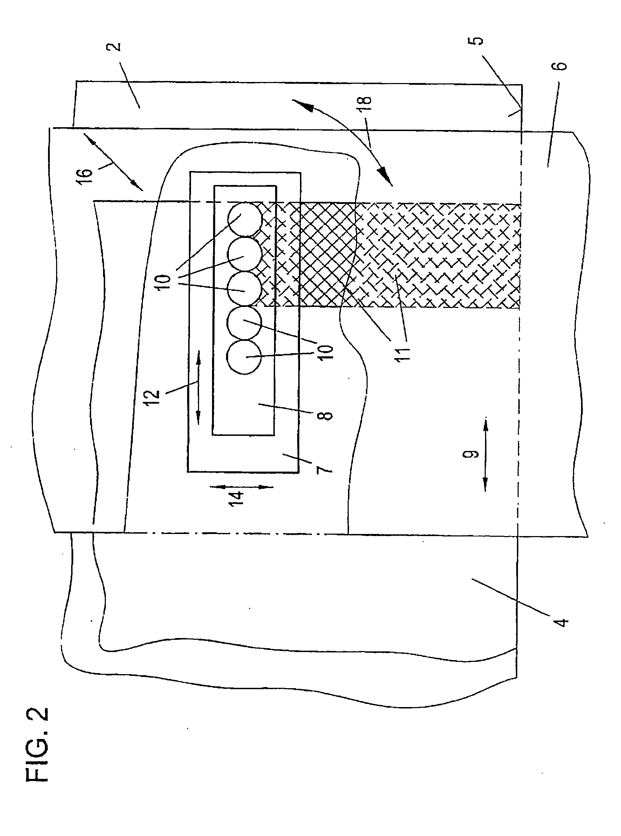

Zum Transportieren der Glasscheibe 4 ist am unteren Rand der Stützwand 2 eine an sich beliebige Fördervorrichtung 5, wie Förderbänder oder Förderrollen, vorgesehen. Zusätzliche Hilfsförderer, die eine genaue Positionierung (Doppelpfeil 9, Fig. 2) der Glasscheibe 4 unterstützen, können ebenfalls vorgesehen sein. Bei horizontaler oder leicht zur Horizontalen geneigter Behandlungsebene werden entsprechend geeignete Positioniermittel vorgesehen.

Vor der Stützfläche 2, die geringfügig (3 bis 5°) nach hinten aus der Vertikalen geneigt ist, ist mit dem Grundgestell 1 starr verbunden ein Balken 6 vorgesehen. Eine Tragplatte 7 (Schlitten) ist auf einer nicht gezeigten, am Balken 6 angeordneten Führung durch einen nicht gezeigten (Linear-)Antrieb entlang des Balkens 6 (Pfeil 14) verfahrbar.

Die Tragplatte 7 trägt einen Träger 8, an dem im gezeigten Ausführungsbeispiel (Fig. 2) fünf Plasmaköpfe 10 in einer Reihe nebeneinander montiert sind. Der Träger 8 für die Plasmaköpfe 10 kann an der Tragplatte 7 um eine zur Glasscheibe 4 senkrechte Achse (Doppelpfeil 18 in Fig. 2) verschwenkbar sein. So ist es möglich, die Reihe aus Plasmaköpfen 10 stets senkrecht zum Rand einer im Randbereich 11 zu entschichtenden Glasscheibe 4 auszurichten, auch wenn die Plasmaköpfe 10 entlang des gesamten Umfangs der Glasscheibe 4 bewegt werden, und so grundsätzlich eine gleichmäßige Behandlungsbreite zu gewährleisten. Abweichend von der Darstellung könnten natürlich auch mehrere Reihen von ggf. gegeneinander versetzten Plasmaköpfen vorgesehen werden.

Zusätzlich kann der Träger 8 mit den Plasmaköpfen 10 an der Tragplatte 7 in deren Längsrichtung (Pfeil 12), also in Richtung der Reihe aus Plasmaköpfen 10, verstellbar montiert sein. Dies hat den Zweck, jeweils so viele Plasmaköpfe 10 im Bereich der Glasscheibe 4 bzw. in der lotrechten Projektion auf das Substrat über einer Überdeckungsfläche anzuordnen, wie es der gewünschten Entschichtungsbreite entspricht. Über den Rand des Substrats hinaus stehende Plasmaköpfe können ggf. abgeschaltet oder auch (teilweise) aktiviert werden, um die Stirnfläche des Substrats mit Plasma zu beaufschlagen.

Dadurch ist es auch möglich, den Träger 8 mit den Plasmaköpfen 10 so auszurichten, dass ein Plasmakopf 10 - der dem Rand der Glasscheibe 4 zugeordnete - so ausgerichtet wird, dass er nur mit einem Teil seiner Wirkbreite zum Entschichten auf die Glasscheibe einwirkt. So kann ein Bereich entschichtet werden, der eine Breite hat, die nicht gleich einem ganzzahligen Vielfachen der Wirkbreite der verwendeten Plasmaköpfe 10 ist.

Zwar sind in den Zeichnungen des Beispiels vereinfachend runde Plasmaköpfe dargestellt, die in einer Reihe angeordnet sind. Es liegt aber auch im Rahmen der vorliegenden Erfindung, die Querschnitte der Plasmaköpfe oder -düsen anders zu gestalten, z. B. in Schlitzform, wobei die effektive Breite des jeweiligen Schlitzes auch variabel sein kann. Eine solche Öffnungsänderung kann z. B. durch bewegliche, ggf. durch Fremdkraft (elektrisch, pneumatisch...) positionierbare Blenden erzeugt werden, und/oder wiederum durch individuelles Nutzen einzelner Düsen bzw. Plasmaquellen, die gegeneinander versetzt angeordnet sein können.

Es ist ohne weiteres aus Fig. 2 ersichtlich und muss daher nicht gesondert dargestellt werden, dass abweichend von der Darstellung an die Stelle der Reihe von (runden) Plasmaköpfen 10 auch eine oder mehrere Schlitzdüsen treten könnten, die einzeln die gesamte von den Köpfen 10 überdeckte Reihe oder Breite oder auch jeweils nur einen Teil davon einnehmen könnten (wobei sich mehrere Schlitzdüsen geringfügig in Vorschubrichtung gesehen überdecken könnten). Breitenänderungen des Entschichtungsbereichs 11 können dann offensichtlich auch durch Ändern des Anstellwinkels der Schlitzdüse(n) bezüglich der Vorschubrichtung eingesteuert werden (dies ist natürlich auch mit den Köpfen 10 möglich, indem analog der Anstellwinkel der von ihnen gebildeten Reihe verändert wird). Eine andere Möglichkeit besteht im Ändern des gegenseitigen Versatzes der Schlitzdüsen, wenn mehrere davon vorgesehen sind. Schließlich könnten auch, wie schon früher erwähnt, Schlitzdüsen oder generell Plasmaköpfe mit veränderlichen Querschnitten verwendet werden.

Zum Verfahren der Tragplatte 7 entlang des Balkens 6 auf den (nicht gezeigten) Führungen in Richtung des Pfeils 14 kann ein elektronisch geregelter Motor vorgesehen sein.

Die Tragplatte 7 kann durch einen Stellmotor in einer Richtung (Pfeil 16) senkrecht zur Fläche der Glasscheibe 4 und der Stützwand 2 verstellt werden, um die Plasmaköpfe 10 im jeweils richtigen Abstand zur Oberfläche der Glasscheibe 4 auch in Abhängigkeit von der Dicke der Glasscheibe 4, die im Randbereich 11 zu entschichten ist, einzustellen.

Zum Verdrehen (Pfeil 18) des Trägers 8 mit den Plasmaköpfen 10 gegenüber der Halteplatte 7 um eine zur Glasscheibe 4 senkrechte Achse ist ein Motor mit integriertem Inkrementalgeber vorgesehen (nicht gezeigt).

Zum Verschieben des Trägers 8 mit den Plasmaköpfen 10 relativ zur Trageplatte 7 können beliebige Linearmotoren (z. B. elektrische, pneumatische) vorgesehen sein.

Abweichend von der Darstellung kann einerseits der Tragbalken 6 entlang der Führung hin und her bewegbar sein. Andererseits kann auch die Führung für die Plasmaköpfe in der Art eines 2D-Plotters mit zwei oder mehr senkrecht zueinander stehenden Führungen aufgebaut sein. Ggf. werden, insbesondere zum Bearbeiten von nicht ebenen Substraten, wie vorerwähnt, noch weitere präzise geführte Freiheitsgrade benötigt. Hierauf ist allerdings nicht näher einzugehen, da solche Vorrichtungen an sich aus dem Stand der Technik bekannt sind.

Die soeben beschriebene Vorrichtung arbeitet wie folgt:

Eine Glasscheibe 4 wird mit ihrer unteren Kante auf der Fördereinrichtung 5 aufstehend und an der Stützfläche 2 über das Luftkissen abgestützt in die richtige Position gegenüber den Plasmaköpfen 10 am Träger 8 ausgerichtet. Zunächst wird der Träger 8 mit den Plasmaköpfen 10 so ausgerichtet, dass die Plasmaköpfe 10 in einer zu einem ersten, lotrechten Rand der Glasscheibe 4 senkrechten Reihe ausgerichtet sind. Die Zahl der Plasmaköpfe 10, die der Glasscheibe 4 gegenüberliegend angeordnet sind, hat der gewünschten Breite der Entschichtung 11 zu entsprechen (alternativ ist es möglich, nur so viele der Plasmaköpfe 10 in Betrieb zu nehmen, wie der gewünschten Breite der Entschichtung 11 entspricht). Dann wird die Trägerplatte 7 zusammen mit dem Träger 8 und den Plasmaköpfen 10 entlang des lotrechten Randes der Glasscheibe 4 nach oben bewegt (Pfeil 14), um den ersten lotrechten Rand der Glasscheibe 4 zu entschichten (Bereich 11, Fig. 2). Durch Verdrehen des Trägers 8 mit den Plasmaköpfen 10 um 90° werden die Plasmaköpfe 10 jetzt so ausgerichtet, dass sie in einer zum oberen horizontalen Rand der Glasscheibe 4 senkrechten Reihe ausgerichtet sind. Dann wird die Glasscheibe 4 entlang der Stützfläche 2 bewegt, so dass der obere Rand entschichtet wird (alternativ besteht die Möglichkeit, die Glasscheibe festzuhalten und den Balken 6, an welchem die Trageplatte 7 und der Träger 8 angeordnet sind, in horizontaler Richtung entlang der Stützfläche 2 zu bewegen). Nachdem der obere Rand der Glasscheibe 4 entschichtet worden ist, wird der Träger 8 erneut um 90° verschwenkt und der zweite lotrechte Rand der Glasscheibe 4 entschichtet, wobei sich der Träger 8 mit der Trageplatte 7 nach unten bewegt. Dabei steht die Glasscheibe 4 still.

Schlussendlich wird der untere horizontale Rand der Glasscheibe 4 entschichtet, indem die Glasscheibe 4 gegenüber dem erneut um 90° verschwenkten Träger 8 mit den Plasmaköpfen 10 bewegt wird.

Das Entschichten selbst erfolgt einerseits durch Hitzeeinwirkung unter dem Einfluss des von den Plasmaköpfen 10 auf die Glasscheibe 4 gerichteten (ggf. mehrfachen) Strahls aus Plasma. Andererseits können, speziell durch Einsatz reaktiver Gase im Plasma, chemische Entschichtungsmechanismen (Ätzen) genutzt werden. Für solche Prozesse eignen sich insbesondere Fluor enthaltende Gase.

Es ist ersichtlich, dass mit der erfindungsgemäßen Vorrichtung die Breite der Entschichtung beliebig gewählt werden kann, indem die Zahl der Plasmaköpfe 10, die benützt werden, entsprechend der Breite 11 gewählt wird, und/oder die Plasmaköpfe 10 durch Linearbewegen des Trägers 8 so ausgerichtet werden, dass nur die jeweils für die gewünschte Entschichtungsbreite benötigten Plasmaköpfe 10 der Glasscheibe 4 gegenüberliegend angeordnet sind. Dabei ist es auch möglich, an der selben Glasscheibe 4 verschiedene Randabschnitte 11 unterschiedlich breit zu entschichten.

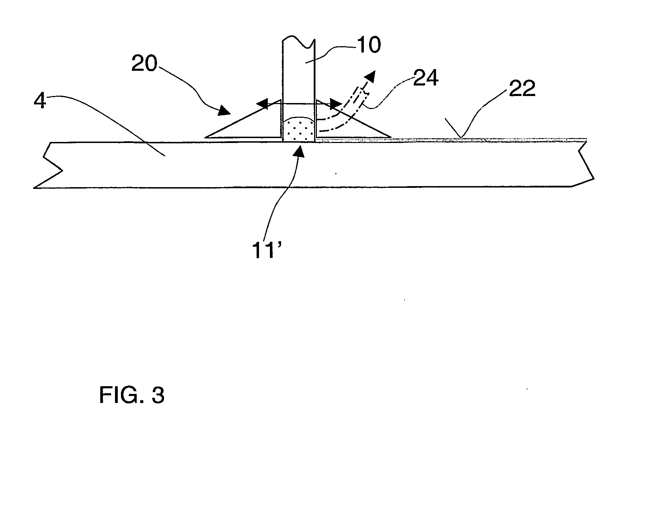

Fig. 3 zeigt schließlich noch sehr schematisch eine unmittelbar an den Arbeitsbereich 11' der Plasmaköpfe 10 angrenzende Abschirmung 20. Die Plasmaköpfe sind hier nur durch den austretenden und auf das beschichtete Substrat 4 bzw. die hier als grauer Belag (der Sichtbarkeit halber mit sehr stark übertriebener Dicke) dargestellte Beschichtung 22 auftreffenden Strahl repräsentiert. Durch einen waagerechten Doppelpfeil ist die relative Beweglichkeit zwischen dem Plasmastrahl und dem Substrat 4 angedeutet. Man erkennt, dass die Beschichtung 22 rechts des Strahls noch intakt ist, während sie links davon abgetragen bzw. entschichtet wurde. Im unteren Bereich des Plasmastrahls direkt oberhalb der Oberfläche des Substrats 4 ist angedeutet, dass sich dort losgelöste Partikel der Beschichtung in undefinierten Bewegungszuständen befinden können.

Die Abschirmung 20 kann den Arbeitsbereich 11' rahmenartig umgeben. Sie soll Verunreinigungen der Beschichtung oder Wiederbeschichtung bereits entschichteter Bereiche oder Flächen durch losgelöste Partikel der Beschichtung 22 verhindern. Zusätzlich kann, wie hier ebenfalls schematisch angedeutet, eine Absaugvorrichtung 24 vorgesehen sein, die die abgelösten Partikel, falls notwendig, und ggf. natürlich auch besonders reaktive (z. B. fluorhaltige) Arbeitsgase unmittelbar entfernt und einer Entsorgung (bzw. im Falle der Arbeitsgase auch einer Wiederverwertung) zuführt. Zweckmäßig wird man diese Abführvorrichtung mit der Abschirmung 20 kombinieren und synchron mit dieser führen, falls beide zugleich in der Anlage vorgesehen sind.

## Patentansprüche

1. Verfahren zum Teil-Entfernen einer Beschichtung von beschichteten Substraten, insbesondere von Glas- oder Kunststdffscheibexl, im Zuge des Vorbereitens der Substrate für nachgeordnete Verwendungen, bei denen eine wenigstens teilweise von der Beschichtung befreite Oberfläche des Substrats benötigt wird, mit Hilfe von Plasma, wobei das Plasma zum lokalen Entfernen der Beschichtung auf den zu entschichtenden Bereich des Substrats gerichtet wird, **dadurch gekennzeichnet, dass** Plasma in einer Reihe aus wenigstens zwei einander, vorzugsweise unmittelbar, benachbarten Strahlen auf die Glasscheibe gerichtet wird, um die Beschichtung auf der zu entschichtenden Teilfläche und/oder wenigstens auf einer Teildicke zu entfernen.

2. Verfahren nach Anspruch 1, **dadurch gekennzeichnet, dass** zum Verändern der Überdeckungsbreite von Plasma und Substrat mindestens ein Plasmastrahl deaktiviert oder aktiviert wird und/oder dass ein Anstellwinkel der durch die Plasmastrahlen gebildeten Reihe bezüglich einer vorschubrichtung verändert wird.

3. Verfahren nach Anspruch 1, **dadurch gekennzeichnet, dass** Plasma aus mindestens einer schlitzförmigen Quelle auf das Substrat gerichtet wird.

4. Verfahren nach Anspruch 3, **dadurch gekennzeichnet, dass** zum Verändern der Überdeckungsbreite von Plasma und Substrat der Querschnitt der schlitzförmigen Quelle verändert und/oder deren Anstellwinkel bezüglich einer Vorschubrichtung verändert wird.

5. Verfahren nach einem der vorstehenden Ansprüche, **dadurch gekennzeichnet, dass** eine kontinuierliche Relativbewegung zwischen dem Plasma und dem zu entschichtenden Substrat gesteuert wird, wobei eine das Plasma abgebende Vorrichtung relativ zum Substrat, das Substrat relativ zu der Plasma abgebenden Vorrichtung oder beide gegeneinander bewegt werden.

6. Verfahren nach einem der vorstehenden Ansprüche, **dadurch gekennzeichnet, dass** eine Relativbewegung zwischen dem Plasma und dem Substrat parallel zum Rand des zu entschichtenden Substrats eingesteuert wird.

7. verfahren, nach einem der vorstehenden Ansprüche, **dadurch gekennzeichnet, dass** eine Reihe von parallelen Plasmastrahlen zum Rand der zu entschichtenden Glasscheibe normal ausgerichtet wird, und dass eine Relativbewegung in einer Vorschubrichtung zwischen dem Substrat und dieser Reihe von Plasmastrahlen quer zu der letzteren gesteuert wird.

8. Verfahren nach einem der vorstehenden Ansprüche, **dadurch gekennzeichnet, dass** eine Reihe von Plasmastrahlen oder eine einen Plasmastrahl abgebende Schlitzdüse im Bereich einer Ecke einer zu entschichtenden Glasscheibe um eine zur Glasscheibe senkrechte Achse geschwenkt wird.

9. Verfahren nach einem der vorstehenden Ansprüche, **dadurch gekennzeichnet, dass** es zum Entschichten des Randes und/oder einer Stirnfläche eines Substrats verwendet wird.

10. verfahren nach einem der vorstehenden Ansprüche, **dadurch gekennzeichnet, dass** das Plasma auch zum Entschichten von stirnkanten oder - flächen des Substrats verwendet wird, wobei die Plasmastrahlen im Wesentlichen in Normalenrichtung auf die Stirnkanten oder -flächen geleitet werden.

11. verfahren nach einem der vorstehenden Ansprüche, **dadurch gekennzeichnet, dass** eine flächige Abschirmung unmittelbar angrenzend an den jeweiligen Arbeitsbereich verwendet wird, welche möglichst nah an der Substratoberfläche positioniert wird.

12. verfahren nach Anspruch 12, **dadurch gekennzeichnet, dass** eine den Arbeitsbereich des Plasmas rahmenartig umgebende Abschirmung verwendet wird.

13. Verfahren nach einem der vorstehenden Ansprüche, **dadurch gekennzeichnet, dass** im Arbeitsbereich abgelöste Partikel mittels einer Abfuhrvorrichtung, insbesondere einer Absaugvorrichtung, unverzüglich entfernt werden.

14. Verfahren nach einem der vorstehenden Ansprüche, **dadurch gekennzeichnet, dass** es zum Entschichten von Flächenbereichen innerhalb der vom Rand des Substrats umschriebenen Fläche, insbesondere zum Entschichten sogenannter Kommunikationsfenster, verwendet wird.

15. Verfahren nach einem der vorstehenden Ansprüche, **dadurch gekennzeichnet, dass** es zum Entfernen von metallischen, oxidischen, nitridischen, organischen Beschichtungen oder Kombinationen der genannten Schichttypen verwendet wird.

16. Verfahren nach einem der vorstehenden Ansprüche, **dadurch gekennzeichnet, dass** es zum Entfernen von hydrophoben und/oder hydrophilen Beschichtungen verwendet wird.

17. Vorrichtung zum Ausführen des Verfahrens nach einem der vorstehenden Ansprüche, umfassend
- eine Stützfläche (2) für das zu entschichtende Substrat (4),
- einen Träger (8) für mindestens eine Plasmaquelle (10),
- eine Einrichtung (5) zum Bewegen des Substrats (4) und
- eine Einrichtung zum Bewegen des Trägers (8) der Plasmaquelle (10),
**dadurch gekennzeichnet, dass** am Träger (a) für die Plasmaquelle wenigstens zwei Plasmaköpfe (10) mit veränderlichem Querschnitt angeordnet sind.

18. Vorrichtung nach Anspruch 17, **dadurch gekennzeichnet, dass** der Träger (8) für den oder die Plasmaköpfe (10) vor der Stützfläche (2) entlang einem im wesentlichen lotrechten Balken (6) durch einen Antrieb verfahrbar ist.

19. vorrichtung nach Anspruch 18, **dadurch gekennzeichnet, dass** der Balken (6) in der Vorrichtung starr oder beweglich montiert ist.

20. Vorrichtung nach Anspruch 18 oder 19, **dadurch gekennzeichnet, dass** der Träger (8) für den oder die Plasmaköpfe (10) um eine zur Ebene der zu entschichtenden Glasscheibe (4) senkrechte Achse (16) verdrehbar ist.

21. Vorrichtung nach einem der Ansprüche 18 bis 20, **dadurch gekennzeichnet, dass** der Träger (8) für den oder die Plasmaköpfe (10) senkrecht zur Ebene der Glasscheibe (4) verstellbar ist.

22. Vorrichtung nach Anspruch 21, **dadurch gekennzeichnet, dass** der Träger (8) für den oder die Plasmaköpfe (10) an einer an Balken (6) geführten Halteplatte (7) verstellbar montiert ist.

23. Vorrichtung nach Anspruch 22, **dadurch gekennzeichnet, dass** der Träger (8) an der Halteplatte (7) um eine zur Ebene der Glasscheibe (4) senkrechte Achse verschwenkbar ist.

24. Vorrichtung nach Anspruch 22 oder 23, **dadurch gekennzeichnet, dass** der Träger (8) an der Halteplatte (7) parallel zur Ebene der Glasscheibe (4) linear verstellbar ist.

25. Vorrichtung nach einem der vorstehenden Vorrichtungsansprüche, **dadurch gekennzeichnet, dass** die Plasmaköpfe (10) an dem Träger (8) in einer Reihe nebeneinander angeordnet sind.

26. Vorrichtung nach Anspruch 25, **dadurch gekennzeichnet, dass** der Träger (8) an der Halteplatte (7) in Richtung der Reihe nebeneinander liegender Plasmaköpfe (10) verstellbar ist.

27. Vorrichtung nach einem der vorstehenden Vorrichtungsansprüche, **dadurch gekennzeichnet, dass** im Arbeitsbereich der Plasmaköpfe bzw. im Bereich des Auftreffens des Plasmas auf das Substrat (4) und auf die Beschichtung (22) eine Abschirmung (20) vorgesehen ist.

28. Vorrichtung nach Anspruch 27, **dadurch gekennzeichnet, dass** die Abschirmung (20) den Arbeitsbereich des Plasmas rahmenartig umgibt.

29. Vorrichtung nach Anspruch 27 oder 28, **dadurch gekennzeichnet, dass** die Abschirmung mit den Plasmaköpfen gemeinsam geführt ist.

30. Vorrichtung nach einem der vorstehenden Vorrichtungsansprüche, **dadurch gekennzeichnet, dass** im Arbeitsbereich der Plasmaköpfe bzw. im Bereich des Auftreffens des Plasmas auf das Substrat (4) und auf die Beschichtung (22) eine Vorrichtung (24) zum Abführen, insbesondere zum Absaugen von losgelösten Partikeln der Beschichtung (22) vorgesehen ist.

31. Vorrichtung nach den Ansprüchen 27 und 30, **dadurch gekennzeichnet, dass** die Vorrichtung (24) mit der Abschirmung (20) zusammengefasst und gemeinsam mit dieser geführt ist.

32. Vorrichtung nach einem der vorstehenden Vorrichtungsansprüche, **dadurch gekennzeichnet, dass** der Träger um mindestens eine zur Fläche des Substrats parallele Achse schwenkbar ist, um das Plasma im Wesentlichen in Normalenrichtung auf eine Stirnkante oder -fläche des Substrats zu lenken.

## Claims

1. Method for partially removing a coating from coated substrates, in particular from glass panes or plastic panes, during the preparation of the substrate for subsequent uses, in which a surface of the substrate at least partially freed of coating is needed, using plasma, wherein the plasma is directed, for local removal of the coating, at the region from which the coating is to be removed, **characterized in that** plasma is directed, in a row of at least two adjacent, preferably immediately adjacent, beams, at the glass pane in order to remove the coating on a sub-area and/or at least on a sub-thickness.

2. Method according to claim 1, **characterized in that**, to change the coverage width of plasma and substrate, at least one plasma beam is deactivated or activated and/or **in that** an angle of attack of the row formed by the plasma beams is changed relative to a feed direction.

3. Method according to claim 1, **characterized in that** plasma is directed onto the substrate from at least one slit-shaped source.

4. Method according to claim 3, **characterized in that**, to change the coverage width of plasma and substrate, the cross-section of the slit-shaped source is changed and/or its angle of attack relative to a feed direction is changed.

5. Method according to one of the preceding claims, **characterized in that** a continuous relative movement between the plasma and the substrate from which the coating is to be removed is controlled, wherein a device emitting the plasma is moved relative to the substrate, the substrate is moved relative to the device emitting the plasma, or both are moved relative to each other.

6. Method according to one of the preceding claims, **characterized in that** a relative movement between the plasma and the substrate is introduced parallel to the edge of the substrate from which the coating is to be removed.

7. Method according to one of the preceding claims, **characterized in that** a row of parallel plasma beams is aligned normal to the edge of the glass plate from which the coating is to be removed, and a relative movement in a feed direction is introduced between the substrate and this row of plasma beams transverse to the latter.

8. Method according to one of the preceding claims, **characterized in that** a row of plasma beams or a slit nozzle emitting a plasma beam is pivoted around an axis perpendicular to the glass pane in the region of a corner of a glass pane from which the coating is to be removed.

9. Method according to one of the preceding claims, **characterized in that** it is used to remove the coating from the edge and/or from an end face of a substrate.

10. Method according to one of the preceding claims, **characterized in that** the plasma is also used to remove the coating from end edges or end faces of the substrate, wherein the plasma beams are directed substantially in the normal direction onto the end edges or end faces.

11. Method according to one of the preceding claims, **characterized in that** a flat shield immediately adjacent to the respective working region is used, which flat shield is positioned as close as possible to the substrate surface.

12. Method according to claim 12, **characterized in that** a shield surrounding the working region of the plasma in a frame-like manner is used.

13. Method according to one of the preceding claims, **characterized in that** particles detached in the working region are immediately removed by a discharge device, in particular a suction device.

14. Method according to one of the preceding claims, **characterized in that** it is used to remove the coating from areas within the area circumscribed by the edge of the substrate, in particular to remove the coating from so-called communication windows.

15. Method according to one of the preceding claims, **characterized in that** it is used to remove metal, oxide, nitride, [or] organic coatings and/or combinations of said layer types.

16. Method according to one of the preceding claims, **characterized in that** it is used to remove hydrophobic and/or hydrophilic coatings.

17. Device for carrying out the method according to one of the preceding claims, comprising
- a supporting surface (2) for the substrate (4) from which the coating is to be removed,
- a carrier (8) for at least one plasma source (10),
- an apparatus (5) for moving the substrate (4), and
- an apparatus for moving the carrier (8) of the plasma source (10),
**characterized in that** at least two plasma heads (10) with a variable cross-section are arranged on the carrier (8) for the plasma source.

18. Device according to claim 17, **characterized in that** the carrier (8) for the plasma head or heads (10) is movable in front of the supporting surface (2) along a substantially vertical bar (6) by means of a drive.

19. Device according to claim 18, **characterized in that** the bar (6) is fixedly or movably mounted in the device.

20. Device according to claim 18 or 19, **characterized in that** the carrier (8) for the plasma head or heads (10) is pivotable around an axis (16) perpendicular to the plane of the glass pane (4) from which the coating is to be removed.

21. Device according to one of claims 18 through 20, **characterized in that** the carrier (8) for the plasma head or heads (10) is adjustable perpendicular to the plane of the glass pane (4).

22. Device according to claim 21, **characterized in that** the carrier (8) for the plasma head or heads (10) is adjustably mounted on a retaining plate (7) guided on bar (6).

23. Device according to claim 22, **characterized in that** the carrier (8) on the retaining plate (7) is pivotable around an axis perpendicular to the plane of the glass pane (4).

24. Device according to claim 22 or 23, **characterized in that** the carrier (8) on the retaining plate (7) is linearly adjustable parallel to the plane of the glass pane (4).

25. Device according to one of the preceding device claims, **characterized in that** the plasma heads (10) are arranged in a row adjacent each other on the carrier (8).

26. Device according to claim 25, **characterized in that** the carrier (8) on the retaining plate (7) is adjustable in the direction of the row of plasma heads (10) adjacent each other.

27. Device according to one of the preceding device claims, **characterized in that** a shield (20) is provided in the working region of the plasma heads or in the region of impact of the plasma on the substrate (4) and on the coating (22).

28. Device according to claim 27, **characterized in that** the shield (20) surrounds the working region of the plasma in a frame-like manner.

29. Device according to claim 27 or 28, **characterized in that** the shield is guided together with the plasma heads.

30. Device according to one of the preceding device claims, **characterized in that** a device (24) for discharging, in particular for suctioning detached particles of the coating (22) is provided in the working region of the plasma heads or in the region of the impact of the plasma on the substrate (4) and on the coating (22).

31. Device according to claims 27 und 30, **characterized in that** the device (24) is integrated with the shield (20) and is guided together with it.

32. Device according to one of the preceding device claims, **characterized in that** the carrier is pivotable around at least one axis parallel to the surface of the substrate to deflect the plasma substantially in the normal direction onto an end edge or end face of the substrate.

## Revendications

1. Procédé d'élimination partielle d'un revêtement sur des substrats revêtus, en particulier des plaques de verre ou de matière plastique, dans le cadre de la préparation des substrats pour des utilisations en aval dans lesquelles il faut une surface du substrat au moins partiellement décapée du revêtement, en utilisant un plasma, le plasma étant dirigé vers la zone du substrat à décaper du revêtement afin d'éliminer localement le revêtement, **caractérisé en ce que** le plasma est orienté vers la plaque de verre sous la forme d'une rangée d'au moins deux jets adjacents, de préférence immédiatement adjacents, afin d'éliminer le revêtement sur la surface partielle à décaper et/ou sur au moins une épaisseur partielle.

2. Procédé selon la revendication 1, **caractérisé en ce qu'**afin de modifier la largeur de superposition du plasma et du substrat, au moins un jet de plasma est désactivé ou activé et/ou **en ce qu'**un angle de positionnement de la rangée formée par les jets de plasma est modifié par rapport à une direction d'avance.

3. Procédé selon la revendication 1, **caractérisé en ce que** le plasma est orienté vers le substrat à partir d'au moins une source en forme de fente.

4. Procédé selon la revendication 3, **caractérisé en ce qu'**afin de modifier la largeur de superposition du plasma et du substrat, la section de la source en forme de fente est modifiée et/ou son angle de positionnement est modifié par rapport à une direction d'avance.

5. Procédé selon l'une des revendications précédentes, **caractérisé en ce qu'**un mouvement relatif continu est piloté entre le plasma et le substrat à décaper, un dispositif produisant le plasma étant déplacé par rapport au substrat, le substrat étant déplacé par rapport au dispositif produisant le plasma ou les deux étant déplacés l'un par rapport à l'autre.

6. Procédé selon l'une des revendications précédentes, **caractérisé en ce qu'**un mouvement relatif entre le plasma et le substrat est piloté parallèlement au bord du substrat à décaper.

7. Procédé selon l'une des revendications précédentes, **caractérisé en ce qu'**une rangée de jets parallèles de plasma est orientée perpendiculairement au bord de la plaque de verre à décaper et **en ce qu'**un mouvement relatif est piloté dans une direction d'avance entre le substrat et cette rangée de jets de plasma, perpendiculairement à cette dernière.

8. Procédé selon l'une des revendications précédentes, **caractérisé en ce qu'**une rangée de jets de plasma ou une buse fendue débitant un jet de plasma est pivotée au niveau d'un coin d'une plaque de verre à décaper, autour d'un axe perpendiculaire à la plaque de verre.

9. Procédé selon l'une des revendications précédentes, **caractérisé en ce qu'**il est utilisé pour décaper le bord et/ou une face frontale d'un substrat.

10. Procédé selon l'une des revendications précédentes, **caractérisé en ce que** le plasma est également utilisé pour décaper des arêtes ou surfaces frontales du substrat, les jets de plasma étant envoyés dans une direction sensiblement perpendiculaire vers les arêtes ou surfaces frontales.

11. Procédé selon l'une des revendications précédentes, **caractérisé en ce qu'**un blindage plan est utilisé à proximité immédiate de la zone de travail considérée et est positionné aussi près que possible de la surface du substrat.

12. Procédé selon la revendication 12, **caractérisé en ce qu'**un blindage est utilisé, qui entoure la zone de travail du plasma à la manière d'un cadre.

13. Procédé selon l'une des revendications précédentes, **caractérisé en ce que** les particules détachées dans la zone de travail sont immédiatement éliminées à l'aide d'un dispositif d'évacuation, en particulier un dispositif d'aspiration.

14. Procédé selon l'une des revendications précédentes, **caractérisé en ce qu'**il est utilisé pour le décapage de zones étendues à l'intérieur de la surface délimitée par le bord du substrat, en particulier pour le décapage de ce que l'on appelle des fenêtres de communication.

15. Procédé selon l'une des revendications précédentes, **caractérisé en ce qu'**il est utilisé pour l'élimination de revêtements métalliques, oxydés, nitrurés, organiques ou de combinaisons de ces types de couches.

16. Procédé selon l'une des revendications précédentes, **caractérisé en ce qu'**il est utilisé pour l'élimination de revêtements hydrophobes et/ou hydrophiles.

17. Dispositif pour l'exécution du procédé selon l'une des revendications précédentes, comprenant .
- une surface d'appui (2) pour le substrat à décaper (4) ;
- un support (8) pour au moins une source de plasma (10) ;
- un appareil (5) destiné à déplacer le substrat (4) ;
- un appareil destiné à déplacer le support (8) de la source de plasma (10) ;
**caractérisé en ce qu'**au moins deux têtes plasma (10) de section variable sont implantées sur le support (8) de la source de plasma.

18. Dispositif selon la revendication 17, **caractérisé en ce que** le support (8) de la ou des têtes plasma (10) est apte à être déplacé devant la surface d'appui (2) le long d'une poutre (6) essentiellement verticale, à l'aide d'un mécanisme d'entraînement.

19. Dispositif selon la revendication 18, **caractérisé en ce que** la poutre (6) est montée fixe ou mobile dans le dispositif.

20. Dispositif selon l'une des revendications 18 ou 19, **caractérisé en ce que** le support (8) de la ou des têtes plasma (10) est apte à pivoter autour d'un axe (16) perpendiculaire à la plaque de verre (4) à décaper.

21. Dispositif selon l'une des revendications 18 à 20, **caractérisé en ce que** le support (8) de la ou des têtes plasma (10) est apte à être déplacé perpendiculairement au plan de la plaque de verre (4).

22. Dispositif selon la revendication 21, **caractérisé en ce que** le support (8) de la ou des têtes plasma (10) est monté mobile sur une plaque de montage (7) guidée sur la poutre (6).

23. Dispositif selon la revendication 22, **caractérisé en ce que** le support (8) est apte à pivoter sur la plaque de montage (7) autour d'un axe perpendiculaire au plan de la plaque de verre (4).

24. Dispositif selon l'une des revendications 22 ou 23, **caractérisé en ce que** le support (8) est apte à être déplacé linéairement sur la plaque de montage (7), parallèlement au plan de la plaque de verre (4).

25. Dispositif selon l'une des revendications précédentes intéressant le dispositif, **caractérisé en ce que** les têtes plasma (10) sont implantées en étant juxtaposées en une rangée sur le support (8).

26. Dispositif selon la revendication 25, **caractérisé en ce que** le support (8) est apte à être déplacé sur la plaque de montage (7) dans la direction de la rangée de têtes plasma (10) juxtaposées.

27. Dispositif selon l'une des revendications précédentes intéressant le dispositif, **caractérisé en ce qu'**il est prévu un blindage (20) dans la zone de travail des têtes plasma ou dans la zone d'impact du plasma sur le substrat (4) et sur le revêtement (22).

28. Dispositif selon la revendication 27, **caractérisé en ce que** le blindage (20) entoure la zone de travail du plasma à la manière d'un cadre.

29. Dispositif selon l'une des revendications 27 ou 28, **caractérisé en ce que** le blindage est guidé en même temps que les têtes plasma.

30. Dispositif selon l'une des revendications précédentes intéressant le dispositif, **caractérisé en ce qu'**il est prévu un dispositif (24) d'évacuation, en particulier d'aspiration, des particules détachées du revêtement (22) dans la zone de travail des têtes plasma ou dans la zone d'impact du plasma sur le substrat (4) et sur le revêtement (22).

31. Dispositif selon l'une des revendications 27 et 30, **caractérisé en ce que** le dispositif (24) est réuni au blindage (20) et est guidé avec celui-ci.

32. Dispositif selon l'une des revendications précédentes intéressant le dispositif, **caractérisé en ce que** le support est apte à pivoter autour d'au moins un axe parallèle à la surface du substrat afin de diriger le plasma selon une direction essentiellement perpendiculaire vers une arête ou une surface frontale du substrat.
